# EUROPÄISCHE PATENTSCHRIFT

(11) **EP 3 392 908 B1**
(45) Veröffentlichungstag und Bekanntmachung des Hinweises auf die Patenterteilung: **24.07.2019**
(21) Anmeldenummer: 17167264.5
(22) Anmeldetag: 20.04.2017
(51) Int. Cl.: H01L 25/11, H05K 1/02

(54) **LEISTUNGSHALBLEITERANORDNUNG MIT EINEM STAPEL VON EINE VERBESSERTE GEOMETRIE AUFWEISENDEN ANSCHLUSSPLATTEN ZUR GEMEINSAMEN ELEKTRISCHEN KONTAKTIERUNGEN MEHRERER, GLEICHARTIGER LEISTUNGSHALBLEITER-SCHALTELEMENTE**
POWER SEMICONDUCTOR ASSEMBLY HAVING A STACK OF CONNECTION PANELS WITH IMPROVED GEOMETRY FOR COMMON ELECTRICAL CONTACTING OF A PLURALITY OF IDENTICAL POWER SEMICONDUCTOR SWITCHING ELEMENTS
SYSTÈME DE SEMI-CONDUCTEUR DE PUISSANCE COMPRENANT UN EMPILEMENT DE PLAQUES DE CONNEXION AYANT UNE GÉOMÉTRIE AMÉLIORÉE POUR LA MISE EN CONTACT ÉLECTRIQUE COMMUNE DE PLUSIEURS ÉLÉMENTS DE COMMUTATEUR SEMI-CONDUCTEUR DE PUISSANCE IDENTIQUE

(43) Veröffentlichungstag der Anmeldung: 24.10.2018
(73) Patentinhaber: Infineon Technologies AG, 85579 Neubiberg (DE)
(72) Erfinder: WISSEN, Matthias, 59329 Wadersloh (DE); GROOVE, Andreas, 59602 Rüthen (DE); DOMES, Daniel, 59602 Rüthen (DE)
(74) Vertreter: Dilg, Haeusler, Schindelmann Patentanwaltsgesellschaft mbH

(56) Entgegenhaltungen:
- EP-A1- 2 028 692
- DE-A1-102008 049 193
- DE-A1-102015 101 086
- DE-A1-102015 109 814

## Beschreibung

Die vorliegende Erfindung bezieht sich auf das Gebiet der Leistungselektronik. Sie betrifft eine Leistungshalbleiteranordnung, die eine Mehrzahl parallel zu verschaltender, gleichartiger, bevorzugt identisch ausgebildeter, in einer Reihe angeordneter Leistungshalbleiter-Schaltelemente aufweist. Pro Schaltelement ist ein Laststromanschluss für die Laststromzufuhr und ein Laststromanschluss für die Laststromabfuhr vorgesehen. Zum schnellen und verlustarmen Schalten von Strömen kommen in der Energie-, Umform- und Übertragungstechnik häufig Leistungstransistoren, insbesondere Bipolartransistoren mit isoliertem Gate (IGBTs), zum Einsatz. Um hohe Ströme (insbesondere in der Größenordnung 1 kA und darüber) schalten zu können, wird dabei eine Vielzahl einzelner Leistungshalbleiterbauelemente, auch nachfolgend Leistungstransistoren genannt, elektrisch parallelgeschaltet. Dabei werden die Leistungstransistoren häufig in Modulen zusammengefasst, was unter anderem eine vereinfachte Handhabung bei Einbau und Austausch ermöglicht, eine definierte und optimierte Kühlung erlaubt, einer Reihe von Sicherheitsaspekten dient usw. Innerhalb eines Moduls sind dabei häufig Bauelementgruppen oder Teilmodule aus Teilmengen der Vielzahl an Leistungstransistoren gebildet. Eine solche Leistungshalbleiteranordnung ist z.B. bereits in der Patentschrift DE 10 2015 109 814 A1 beschrieben worden.

Hinsichtlich des Schaltverhaltens der Leistungshalbleiteranordnung ist es im Allgemeinen gewünscht, dass ein Strom möglichst schnell ein- bzw. ausgeschaltet werden kann. Insbesondere bei spannungsgesteuerten Leistungstransistoren, bei welchen ein Strom zwischen einer ersten Leistungselektrode und einer zweiten Leistungselektrode mittels einer zwischen erster Leistungselektrode und einer Steuerelektrode anliegenden Steuerspannung schaltbar ist, wird dies unter anderem durch induktive Effekte erschwert. Diese induktiven Effekte betreffen nicht nur die Steuerspannung und bewirken eine Abweichung der wirksamen Steuerspannung von der vorgegebenen Steuerspannung, sondern betreffen auch die Laststromabfuhr und Laststromzufuhr.

So erfolgt ferner eine induktive Beeinflussung durch zeitlich veränderliche Ströme durch die restlichen Leistungstransistoren aufgrund von sogenannten Gegeninduktivitäten. In stromdurchflossenen Leitern, so auch um die Laststromanschlüsse bilden sich darüber hinaus Magnetfelder aus. Der in den Anschlüssen fließende elektrische Strom führt zur Ausbildung eines magnetischen Flusses. Wie diese Magnetfelder sich im Raum um den stromdurchflossenen Leiter ausbreiten und wie groß der dadurch resultierende magnetische Fluss wird, hängt von den magnetischen Eigenschaften der Umgebung ab. Dabei spielen nicht nur die magnetischen Eigenschaften der Materialien in der Umgebung sondern auch das Vorhandensein weiterer Magnetfelder, verursacht durch andere Laststromanschlüsse, eine ausschlaggebende Rolle. Durch Parallelschaltung von mindestens zwei Leistungshalbleiter-Schaltelementen entsteht eine magnetische Beeinflussung der einzelnen laststromführenden Pfade derart, dass sich deren Induktivitäten stark unterscheiden können. Dies führt zu einer ungleichmäßigen Stromaufteilung, auch asymmetrische Stromaufteilung genannt, vor allem während des Schaltaugenblicks, so dass das Schaltverhalten der gesamten Leistungshalbleiteranordnung hiervon beeinflusst wird.

Es hat sich gezeigt, dass mittels der Art und Weise der Kontaktierung von Leistungshalbleiter-Schaltelementen das Problem der Stromasymmetrie adressiert werden kann, indem beispielsweise durch unterschiedliche geometrische Ausbildung der Anschlusszungen und/oder durch separate Schirmungen eines oder mehrerer Leistungshalbleiter-Schaltelemente die Induktivitäten "symmetriert" werden können und die Stromasymmetrie während des Schaltens der Leistungshalbleiter-Schaltelemente weitgehend eliminiert werden kann.

Es hat sich aber ferner gezeigt, dass es durch den sogenannten Skin-Effekt zu einer ungleichmäßigen Stromaufteilung insbesondere bei hochfrequenten Stromanteilen während des Schaltvorgangs kommt, da sich die hochfrequenten Stromanteile oberflächennah und insbesondere kantennah ausbreiten. Bei mehreren über eine gemeinsame Anschlussplatte pro Laststromrichtung kontaktierten Leistungshalbleiter-Schaltelementen führt dies dazu, dass außenliegende Leistungshalbleiter-Schaltelemente eine höhere, innenliegende Leistungshalbleiter-Schaltelemente eine geringere resultierende Kommutierungsinduktivität aufweisen.

Vor diesem Hintergrund besteht die der Erfindung zugrundeliegende Aufgabe nun darin, eine eine Mehrzahl parallel zu verschaltender, bevorzugt identisch ausgebildeter, in einer Reihe angeordneter Leistungshalbleiter-Schaltelemente aufweisende Leistungshalbleiteranordnung bereitzustellen, deren Schaltverhalten verbessert ist, insbesondere bei der das Schaltverhalten der einzelnen Leistungshalbleiter-Schaltelemente besser aneinander angeglichen ist. Diese Aufgabe wird durch eine Leistungshalbleiteranordnung gemäß Anspruch 1 gelöst. Vorteilhafte Ausgestaltungen sind jeweils Gegenstand der abhängigen Ansprüche. Es ist darauf hinzuweisen, dass die in den Ansprüchen einzeln aufgeführten Merkmale in beliebiger, technologisch sinnvoller Weise miteinander kombiniert werden können und weitere Ausgestaltungen der Erfindung aufzeigen. Die Beschreibung, insbesondere im Zusammenhang mit den Figuren, charakterisiert und spezifiziert die Erfindung zusätzlich.

Die Erfindung betrifft eine Leistungshalbleiteranordnung, welche eine Mehrzahl parallel zu verschaltender, in einer Reihe angeordneter, gleichartiger Leistungshalbleiter-Schaltelemente aufweist. Jedes Leistungshalbleiter-Schaltelement weist einen Laststromanschluss pro Laststromrichtung auf, d.h. einen Laststromanschluss für die Laststromzufuhr und einen Laststromanschluss für die entgegengesetzte Laststromrichtung, nämlich die Laststromabfuhr. Diese Anschlüsse werden auch als DC+ und DC- Anschlüsse bezeichnet. Darüber hinaus können erfindungsgemäß weitere Anschlüsse, wie wenigstens ein Phasenanschluss für einen Wechselstrom vorgesehen sein. Anders ausgedrückt, der jedem Leistungshalbleiter-Schaltelement über die vorgenannten Laststromanschlüsse zugeführte elektrische Energie wird in einer Ausgestaltung über andere Anschlüsse beispielsweise unter Stromumwandlung abgeführt. Erfindungsgemäß soll ferner nicht ausgeschlossen sein, dass pro Leistungshalbleiter-Schaltelement auch mehrere Laststromanschlüsse derselben Laststromrichtung vorgesehen sind. Die Leistungshalbleiteranordnung insgesamt betrachtet ergeben sich somit mehrere Laststromanschlüsse pro Laststromrichtung aus Laststromzufuhr und Laststromabfuhr. Der Begriff "gleichartig" ist weit auszulegen und meint beispielsweise eine Übereinstimmung in der Bauweise aber nicht zwingend ein identisches Schaltverhalten. Der Begriff "Leistungshalbleiter-Schaltelement" ist ebenfalls weit auszulegen und kann ein einzelnes oder mehrere Halbleiterbauelemente pro Schaltelement beinhalten. Das "Leistungshalbleiter-Schaltelement" wird im Folgenden auch als Modul bezeichnet, welches beispielsweise durch Schraubverbindungen an einem Kühlkörper befestigt wird und durch Schraubverbindungen über Kontaktierungseinrichtungen elektrisch kontaktiert wird.

Es kann sich ferner um nicht gehauste Leistungshalbleiter-Schaltelemente handeln. Bevorzugt handelt es sich jeweils um ein gehaustes, d.h. ein Modulgehäuse aufweisendes Leistungshalbleiter-Schaltelement. Die Modulgehäuse sind beispielsweise jeweils aus einem Kunststoff, bevorzugt einem faserverstärkten Kunststoff, wie einem glasfaserverstärkten Thermoplast. Beispielsweise handelt es sich bei dem Leistungshalbleiter-Schaltelement jeweils um ein IGBT (Insulated Gate Bipolar Transistor) oder jeweils einen MOSFET (Metalloxidhalbleiter-Feldeffekttransistor). Ferner kann eine zweite - unterschiedliche oder gleiche - Anzahl gegenparallel geschalteter Dioden, insbesondere als Schutzdiode (engl.: "freewheeling", "snubber-" oder "flyback-"Dioden) vorgesehen sein, insbesondere in Leistungshalbleiter-Schaltelementen, die als oder für den Einsatz in Brücken- oder Halbbrückenschaltungen ausgelegt sind.

Erfindungsgemäß weist die Leistungshalbleiteranordnung ferner jeweils eine Anschlussplatte als Teil der elektrischen Kontaktierungseinrichtung pro Laststromrichtung zur elektrischen Kontaktierung und Befestigung mehrerer, insbesondere aller, Laststromanschlüsse derselben Laststromrichtung aus Laststromzufuhr oder Laststromabfuhr auf. So ist je eine Anschlussplatte, eine für die Laststromzufuhr und eine für die Laststromabfuhr vorgesehen. Die Anschlussplatte ist beispielsweise jeweils aus einem leitfähigen Material, wie einem Metall oder einer metallischen Legierung. Bevorzugt ist die Anschlussplatte jeweils aus gelasertem oder gestanztem Metallblech, wie Kupferblech.

Die Anschlussplatten sind elektrisch isoliert zueinander angeordnet. Beispielsweise sind die Anschlussplatten über einen Luftspalt und/oder eine Isolierschicht aus einem Dielektrikum beabstandet zueinander angeordnet. Die Anschlussplatten sind ferner in einer Stapelrichtung gestapelt angeordnet. Mit Befestigung ist eine Befestigung am zugehörigen Laststromanschluss beispielsweise mittels einer oder mehrerer Schraubbefestigungsmittel gemeint. Als Anschlussplatte wird der Teil der Kontaktierungseinrichtung verstanden, der wenigstens den für die unmittelbar angrenzende Anordnung an den zugehörigen Laststromanschluss bestimmten Abschnitt der jeweiligen Kontaktierungseinrichtung darstellt. Bevorzugt weist die Kontaktierungseinrichtung pro Laststromrichtung einen oder mehrere vorgeordnete Leiter auf und die Anschlussplatte stellt jeweils das letzte Stück des "Weges" zwischen diesem Leiter und den betreffenden Laststromanschlüssen dar und dient der Stromverteilung zu oder aus den zugehörigen Laststromanschlüssen.

Jede der Anschlussplatten erstreckt sich jeweils entlang einer ersten Erstreckungsrichtung von einer Einspeisungskante zu einer Endkante. Der Begriff "Kante" ist weit auszulegen und soll keinen zwingend geradlinigen Verlauf der jeweiligen Kante implizieren, bevorzugt ist der Verlauf geradlinig. Alternativ wird die Einspeisungskante auch als Einspeisungsseite bezeichnet. Dabei erstreckt sich die Anschlussplatte in der ersten Erstreckungsrichtung über die zugehörigen Laststromanschlüsse hinweg, wobei diese Laststromanschlüsse zum Zwecke der Befestigung und elektrischen Kontaktierung durch die jeweilige Anschlussplatte berührt werden. Bevorzugt bildet die Anschlussplatte eine Einspeisekante aus, die der Endkante gegenüberliegt. Jede Anschlussplatte erstreckt sich ferner entlang einer zweiten, zur ersten Erstreckungsrichtung orthogonalen und zur gedachten Linie parallelen Erstreckungsrichtung jeweils zwischen zwei Längskanten, die bevorzugt parallel zueinander laufen.

Als Einspeisungsseite bzw. Einspeisungskante wird die Seite bzw. Kante verstanden, über die der allen zugehörigen Laststromanschlüssen zuzuführende Laststrom zugeführt wird beziehungsweise über die aus allen zugehörigen Laststromanschlüssen abzuführende Laststrom abgeführt wird. Beispielsweise handelt es sich um die Seite, insbesondere Kante, der Anschlussplatte, die zur Verbindung mit weiteren Leitern oder elektrischen Komponenten, beispielsweise Komponenten eines Zwischenkreises, ausgebildet ist.

Zur Verbesserung des Schaltverhaltens werden zwei Maßnahmen vorgeschlagen die alternativ aber auch kombiniert erfindungsgemäß angewandt werden können:
Gemäß einer ersten Maßnahme ist wenigstens eine der Anschlussplatten, bevorzugt beide Anschlussplatten, mehrfach mittels zwischen den benachbarten Lastromanschlüssen derselben Lastromrichtung verlaufenden Schlitzen geschlitzt, so dass die betreffende Anschlussplatte jeweils durch die Schlitze definierte, jeweils einem Laststromanschluss zugeordnete Sektionen ausbildet, und benachbarte Sektionen lediglich auf der Einspeisungsseite, bevorzugt lediglich an der Einspeisungskante, elektrisch leitend verbunden sind. Durch die mehrfachen Schlitze kommt es aufgrund des Skin-Effekts zu einer Steigerung der Stromdichte hochfrequenter Schaltstromanteile im dem durch die Schlitze definierten Kantenbereich. Dies hat zur Folge, dass gegenüber einer schlitzlosen Ausführung die sich aus der schlitzlosen Ausführung ergebenden Induktivitätsasymmetrie und die daraus resultierende Kommutierungsinduktivität verringert werden können.

Gemäß einer zweiten Maßnahme ist wenigstens eine der Anschlussplatten entlang der Längskanten in Richtung der anderen Anschlussplatte unter Ausbildung eines Winkelabschnitts abgekantet. Darunter wird jeweils ein die andere Anschlussplatte übergreifender Abschnitt an der Längsseite der betreffenden Anschlussplatte verstanden, der bezüglich der beiden Erstreckungsrichtungen angewinkelt, bevorzugt orthogonal angeordnet ist und der der benachbarten Anschlussplatte zugewandt ist, ohne diese Anschlussplatte zu berühren. Beispielsweise ist die durch die Abkantung definierte endständige Kante einer Anschlussplatte in der durch die andere Anschlussplatte definierten Ebene angeordnet oder der durch die Abkantung sich ergebende Abschnitt erstreckt sich bevorzugt über die durch die andere Anschlussplatte definierte Ebene hinaus. Dadurch wird beispielsweise die durch den Skin-Effekt hervorgerufenen hohen Schaltstromdichten durch elektromagnetische Wechselwirkung an den sich überstehenden Kanten unterschiedlicher Laststromrichtung reduziert.

Aufgrund der durch diese Maßnahme veränderten relativen Lage der äußeren Kanten der Anschlussplatten unterschiedlicher Laststromrichtung kommt es gegenüber einer Ausbildung der Anschlussplatten als ein Stapel aus ebenen Anschlussplatten zu einer Verringerung der bei dieser Ausbildung vorhandenen Induktivitätsasymmetrie.

Beide zuvor beschriebenen Maßnahmen können einzeln oder in Kombination zur Anwendung kommen.

Gemäß einer Ausgestaltung ist die jeweils geschlitzte Anschlussplatte von der Einspeisungskante bis zur gegenüberliegenden Endkante durchgehend geschlitzt. Die elektrische Verbindung zwischen den Sektionen auf der Einspeisungsseite wird beispielsweise jeweils durch einen oder mehrere separate Leiterabschnitte bereitgestellt. Die Sektionen sind dabei durch die Schlitze mechanisch separiert und gegebenenfalls zur mechanischen Stabilisierung auf einem gemeinsamen Träger aus elektrisch isolierendem Material angeordnet.

Zur Vereinfachung der Herstellung ist bevorzugt vorgesehen, dass die Schlitze sich von der Endkante in Richtung Einspeisungskante bis zu einem von der betreffenden Anschlussplatte ausgebildeten verbleibenden Verbindungssteg zu erstrecken, ohne somit die Einspeisungskante zu erreichen, so dass die Anschlussplatte jeweils nicht durchgehend geschlitzt ist. Der Verbindungssteg ist somit aus dem Material der Anschlussplatte ausgebildet und wird während des Herstellungsschritt der Anschlussplatte in diese, beispielsweise durch Lasern oder Stanzen, eingebracht. Der Verbindungssteg erstreckt sich beispielsweise jeweils angrenzend und entlang der Einspeisungskante.

Die Schlitze der ersten genannten Maßnahme können beispielsweise schräg zur ersten und zweiten Erstreckungsrichtung verlaufen. Gemäß einer bevorzugten Ausgestaltung erstreckt sich der Schlitz jeweils parallel zur Längskante. Noch bevorzugter verlaufen die Schlitze parallel zueinander und jeweils entlang der geometrischen Mittellinie zwischen nächstbenachbarten Laststromanschlüssen entgegengesetzter Laststromrichtungen.

Bevorzugt ist vorgesehen, dass die Laststromanschlüsse jeweils näher benachbart zur zugehörigen Endkante als zur Einspeisungskante angeordnet sind. Beispielsweise verläuft die durch die Laststromanschlüsse definierte Linie parallel zur Endkante. Beispielsweise liegt der Abstand zwischen der Linie und der Endkante im Bereich von 0,5 bis 3,0 cm, bevorzugt im Bereich von 1,0 bis 2,5 cm.

Bevorzugt sind die Anschlussplatten mit zueinander parallel verlaufenden Schlitzen versehen. Noch bevorzugter sind die Anschlussplatten mit in Stapelrichtung zur Deckung gebracht und deckungsgleich verlaufenden Schlitzen versehen.

Zur Erreichung einer besonders gleichförmigen Stromverteilung sind gemäß einer bevorzugten Ausgestaltung die jeweils durch die Schlitze definierten, jeweils einem Laststromanschluss zugeordneten Sektionen der zugehörigen Anschlussplatte, bevorzugt für beide Laststromrichtungen, deckungsgleich, d.h. wenigstens bezüglich ihrer Abmessungen in Richtung der ersten und zweiten Erstreckungsrichtung übereinstimmend, ausgebildet.

Bevorzugt weisen die Schlitze entlang ihres Verlaufs einen maximalen lichten Abstand, d.h. eine maximale Schlitzbreite, von weniger als 5,0 mm, wie 2,5 mm, noch bevorzugter weniger als 1 mm auf. Bevorzugt ist der lichte Abstand über den Verlauf der Schlitze gleichbleibend. Die Schlitze der Anschlussplatten können einen übereinstimmenden lichten Abstand aufweisen. In einer bevorzugten Ausgestaltung können die Anschlussplatten unterschiedlicher Laststromrichtung einen unterschiedlichen lichten Abstand aufweisen, wobei die zur jeweiligen Anschlussplatte gehörigen Schlitze den identischen lichten Abstand aufweisen. Beispielsweise weist die den Leistungshalbleiter-Schaltelementen näher angeordnete Anschlussplatte Schlitze mit größerem lichten Abstand auf, als die zu den Schaltelementen weiter entfernten Anschlussplatte gehörigen Schlitze.

Bevorzugt weisen die Schlitze eine Länge von mehr als 2,5 cm bis 10,0 cm, bevorzugt mehr als 3,5 cm bis 8,0 cm auf.

Bevorzugt weist der Verbindungssteg jeweils eine durch die Länge der Schlitze definierte Breite von weniger als 1,5 cm, bevorzugt weniger als 1,0 cm auf.

Gemäß einer bevorzugten, eine Kombination der ersten und zweiten Maßnahme aufweisenden Ausgestaltung definieren die Schlitze zugehörige Schlitzkanten, und eine der Anschlussplatten ist entlang der Schlitzkanten in Richtung der anderen Anschlussplatte unter Ausbildung des besagten Winkelabschnitts abgekantet. Diese erstrecken sich beispielsweise durch den in Stapelrichtung nächstbenachbarten Schlitz der jeweilig anderen Anschlussplatte, d.h. der für die entgegengesetzte Stromrichtung vorgesehenen Anschlussplatte.

Bevorzugt weist eine der Anschlussplatten mehrere Durchbrüche auf, die jeweils für die Durchführung des Lastromanschlusses und/oder den Zugriff zu einem der Laststromanschlüsse der anderen Anschlussplatte vorgesehen sind. Hierbei definiert der Durchbruch jeweils eine geschlossen umlaufende Durchbruchkante und ist bevorzugt versetzt zu den Kanten, wie Längskanten, Einspeisungskante, Endkante und Schlitzkanten der jeweiligen Anschlussplatte angeordnet. Der Verlauf der Durchbruchkante ist beispielsweise oval, kreisrund, im Wesentlichen rechteckig. Als im Wesentlichen rechteckig wird ein rechteckiger Verlauf mit gerundeten Ecken verstanden. Durch den Versatz des Durchbruchs von den Kanten der Anschlussplatte unterscheidet sich der Durchbruch von einer seitlichen Aussparung der Anschlussplatte und beeinträchtigt damit nicht die gemäß der erfindungsgemäßen Lehre intendierte Stromverteilung hochfrequenter Stromanteile entlang der Kanten der Anschlussplatte.

Bevorzugt sind die Modulgehäuse der Leistungshalbleiteranordnung identisch ausgebildet. Bevorzugt sind die Anschlussplatten die Modulgehäuse überdeckend ausgebildet.

Gemäß einer bevorzugten Ausgestaltung weisen die Modulgehäuse lange und kurze Flanken auf, die so angeordnet sind, dass bis auf eine Flanke des äußersten Modulgehäuses jeweils eine lange Flanke eines Modulgehäuses nächstbenachbart, beispielsweise angrenzend, mit einer Flanke eines anderen Modulgehäuses angeordnet ist.

Gemäß einer bevorzugten Ausgestaltung sind die Anschlussplatten so angeordnet, dass sie eine alle Modulgehäuse der Leistungshalbleiteranordnung umgebende Kühleinrichtung, beispielsweise eine Flüssigkeitskühleinrichtung, überbrücken. Beispielsweise liegt die Einspeisungskante außerhalb des durch die Kühleinrichtung definierten Außenumfangs.

Die Erfindung betrifft ferner die Verwendung der Leistungshalbleiteranordnung in einer der zuvor beschriebenen Ausführungsformen als Stromrichter. Als Stromrichter werden ruhende elektrische Geräte bzw. Anlagen - das heißt ohne bewegliche Teile, aber nicht notwendig stationär - zur Umwandlung einer eingespeisten elektrischen Stromart (Gleichstrom, Wechselstrom) in die jeweils andere, oder zur Änderung charakteristischer Parameter wie der Spannung und der Frequenz verstanden. Bevorzugt wird sie als Wechselrichter, beispielsweise als Stromzwischenkreiswechselrichter, noch bevorzugter als Spannungszwischenkreiswechselrichter verwendet.

Diese und weitere Aufgaben, Vorteile und Merkmale der Erfindung werden aus der nachfolgenden, detaillierten Beschreibung bevorzugter Ausführungsbeispiele der Erfindung in Verbindung mit den Zeichnungen offensichtlich.
- Figur 1: zeigt eine Aufsicht auf eine erfindungsgemäße, erste Ausführungsform der Leistungshalbleiteranordnung;
- Figur 2: zeigt eine vertikale Schnittansicht durch die erfindungsgemäße Ausführungsform aus Figur 1;
- Figur 3: zeigt in Schnittansicht eine zweite erfindungsgemäße Ausführungsform;
- Figur 4: zeigt in Schnittansicht die Anschlussplatten einer dritten erfindungsgemäßen Ausführungsform;
- Figur 5: zeigt in Schnittansicht die Anschlussplatten einer vierten erfindungsgemäßen Ausführungsform;
- Figur 6: zeigt in Schnittansicht die Anschlussplatten einer fünften erfindungsgemäßen Ausführungsform;
- Figur 7: zeigt in Schnittansicht die Anschlussplatten einer sechsten erfindungsgemäßen Ausführungsform;
- Figur 8: zeigt in Schnittansicht die Anschlussplatten einer siebten erfindungsgemäßen Ausführungsform;
- Figur 9: ein Ersatzschaltbild für ein als Halbbrücke ausgelegtes Leistungshalbleiter-Schaltelement.

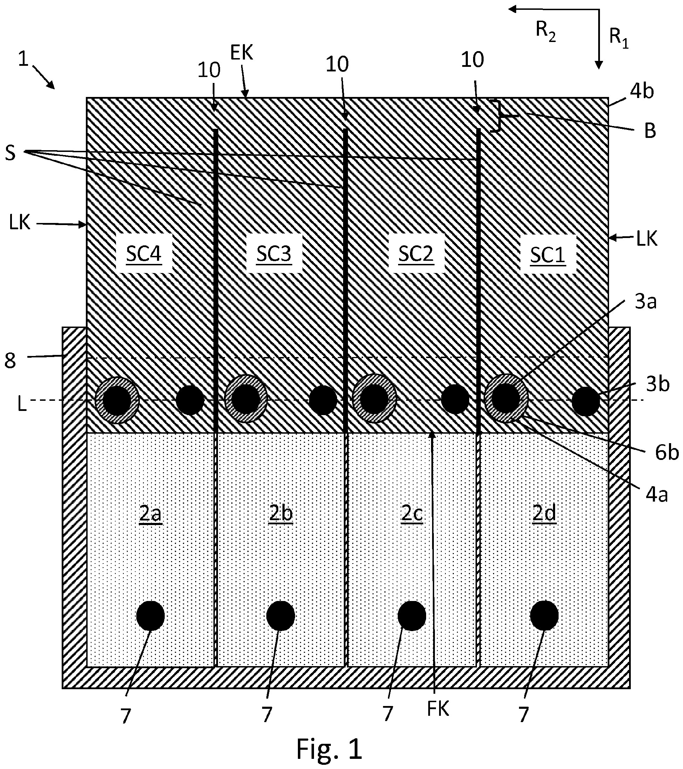

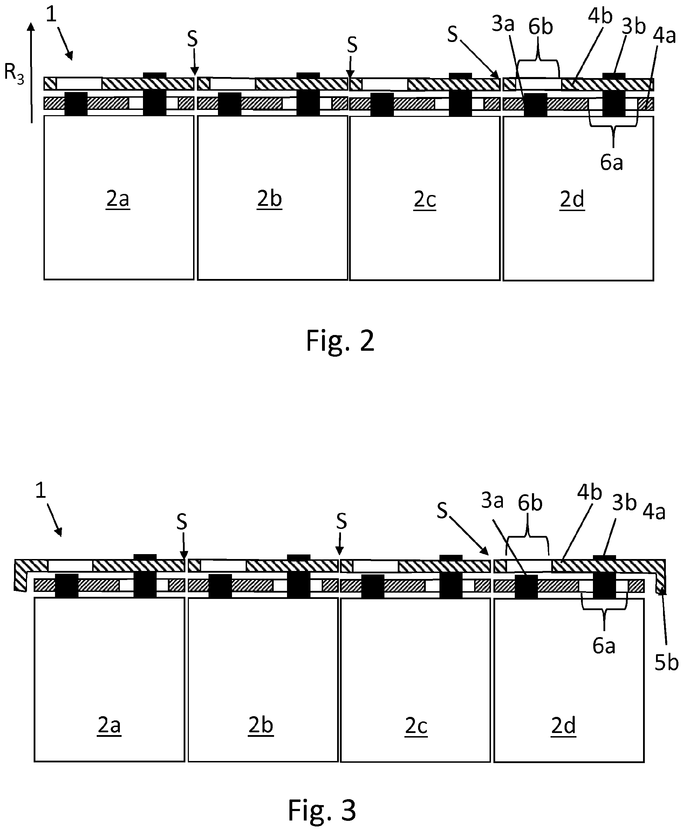

Figur 1 zeigt eine Aufsicht auf eine erfindungsgemäße, erste Leistungshalbeiteranordnung 1. Zur weiteren Erläuterung ist die zugehörige Schnittansicht der Figur 2 als Schnitt entlang der Linie L aus Figur 1 beigefügt. Im Folgenden, sofern nicht anders angegeben, wird auf die beiden Figuren Bezug genommen. Die Leistungshalbleiteranordnung umfasst mehrere identisch ausgebildete in einem zugehörigen Modulgehäuse gehauste Halbbrücken 2a, 2b, 2c, 2d, die mit ihren längeren Längsseiten parallel nebeneinander angeordnet sind. Diese weisen auf ihrer Oberseite Laststromanschlüsse 3a für die Laststromzufuhr und Laststromanschlüsse 3b für die Laststromabfuhr sowie Phasenanschlüsse 7 auf. Sämtliche Laststromanschlüsse 3a, 3b sind auf einer gedachten Linie L angeordnet. Diese Anschlüsse 3a und 3b sind mit zugehörigen Anschlussplatten 4a und 4b durch Verschraubung elektrisch verbunden, d.h. die für die Laststromabfuhr vorgesehenen Lastanschlüsse 3b sind mit der zugehörigen Anschlussplatte 4b verbunden, während die für die Laststromzufuhr vorgesehenen Laststromanschlüsse 3a mit der zugehörigen Anschlussplatte 4a verbunden sind. Die Anschlussplatte 4b für die Laststromabfuhr ist über der Anschlussplatte 4a für die Laststromzufuhr angeordnet.

Beide sind übereinander in der Stapelrichtung R₃ gestapelt und parallel zueinander und aufgrund einer Luftspaltbeabstandung elektrisch isoliert zueinander angeordnet. Wie Figur 1 und 2 zeigen, sind die Anschlussplatten 4a, 4b deckungsgleich ausgebildet und weisen somit übereinstimmende Außenabmessungen auf. Sie überdecken die Modulgehäuse der Halbbrücken 2a, 2b, 2c, 2d lediglich teilweise. Dabei erstrecken sie sich jeweils entlang einer ersten Erstreckungsrichtung R₁ von einer Einspeisungskante EK zu den zugehörigen Laststromanschlüssen 3a bzw. 3b, um diese zu berühren und weiter bis zur Endkante FK. Dabei stehen die Anschlussplatte 4b mit den zugehörigen Laststromanschlüssen 3b und die Anschlussplatte 4a mit den zugehörigen Laststromanschlüssen 3a durch kraftschlüssige Verbindung in Berührung und die Laststromanschlüsse 3a bzw. 3b sind jeweils näher zur Endkante FK als zur Einspeisungskante EK angeordnet. Die Einspeisungskante EK muss nicht zwingend einen geradlinigen Verlauf aufweisen und ist die Kante der Anschlussplatte 4a, 4b, über die der gesamte Laststrom zu- bzw. abgeführt wird. Beispielsweise wird der Strom jeweils über einen den Halbbrücken 2a, 2b, 2c, 2d parallel vorgeschalteten, nicht näher dargestellten Kondensator mit seinen Anschlüssen zu- bzw. abgeführt.

Die Anschlussplatten 4a, 4b erstrecken sind entlang einer zweiten, zur ersten orthogonalen Erstreckungsrichtung zwischen den parallelen Längskanten LK, die sich auf Höhe der Längsflanken der äußeren Modulgehäuse der Anordnung 1 befinden. Die Anschlussplatten 4a und 4b überbrücken jeweils eine Kühleinrichtung 8, die angrenzend an die Unterseite der Module 2a, 2b, 2c, 2d angeordnet ist und deren Außenumfang seitlich überragt. Beide Anschlussplatten 4a, 4b sind durch Schlitze S bis auf die jeweils zwischen dem jeweiligen Schlitz S und der Einspeisungskante EK der Anschlussplatte 4a, 4b verbleibenden Verbindungssteg 10 in deckungsgleiche Sektionen SC1, SC2, SC3, SC4 "segmentiert". Dabei bildet der verbleibende Verbindungssteg 10 das die Sektionen SC1, SC2, SC3, SC4 verbindende Element an der Einspeisekante EK aus, die auf der die sogenannte Einspeisungsseite definierenden Seite der jeweiligen Anschlussplatte 4a bzw. 4b angeordnet ist.

Die Schlitze S in beiden Anschlussplatten 4a, 4b sind deckungsgleich ausgestaltet und zur Deckung gebracht angeordnet. Sie erstrecken sich jeweils entlang der geometrischen Mittellinie zwischen nächstbenachbarten, entgegengesetzten Stromanschlüssen von der Endkante FK in Richtung Einspeisungskante EK bis zum Verbindungssteg 10, ohne die Anschlussplatte 4a, 4b somit vollständig zu durchziehen. In jeder Sektion SC1, SC2, SC3, SC4 ist ein Lastanschluss der zugehörigen Laststromrichtung, im Falle der Anschlussplatte 4b ein Lastanschluss 3b vorgesehen, wobei für die Durchführung durch die obere Anschlussplatte 4b bzw. den Zugriff durch die obere Anschlussplatte 4b zum Lastanschluss 3a der unteren Anschlussplatte 4a diese jeweils einen kreisrunden Durchbruch 6a bzw. 6b aufweisen, die jeweils beabstandet zu sämtlichen Kanten, der Endkante FK, der Einspeisungskante EK und zu den durch die Schlitze S definierten Schlitzkanten angeordnet sind. Beispielsweise beträgt der Abstand des Durchbruchs zur jeweiligen Endkante 0,5 bis 1,0 cm.

Figur 3 zeigt eine zweite Ausführungsform der erfindungsgemäßen Leistungshalbleiteranordnung 1. Diese unterscheidet sich von der in den Figuren 1 und 2 gezeigten Ausführungsform, dass die für die Laststromabfuhr vorgesehene Anschlussplatte 4b unter Ausbildung von orthogonal zu der zweiten Erstreckungsrichtung verlaufenden Winkelabschnitten 5b entlang beider Längskanten abgekantet ist. Die Winkelabschnitte 5b erstrecken sich dabei über die Anschlussplatte 4a der Laststromzufuhr hinaus, ohne diese zu berühren. Die zuvor in Bezug auf die erste Ausführungsform der Figuren 1 und 2 vorgesehenen Schlitze S sind entsprechend ebenfalls vorgesehen.

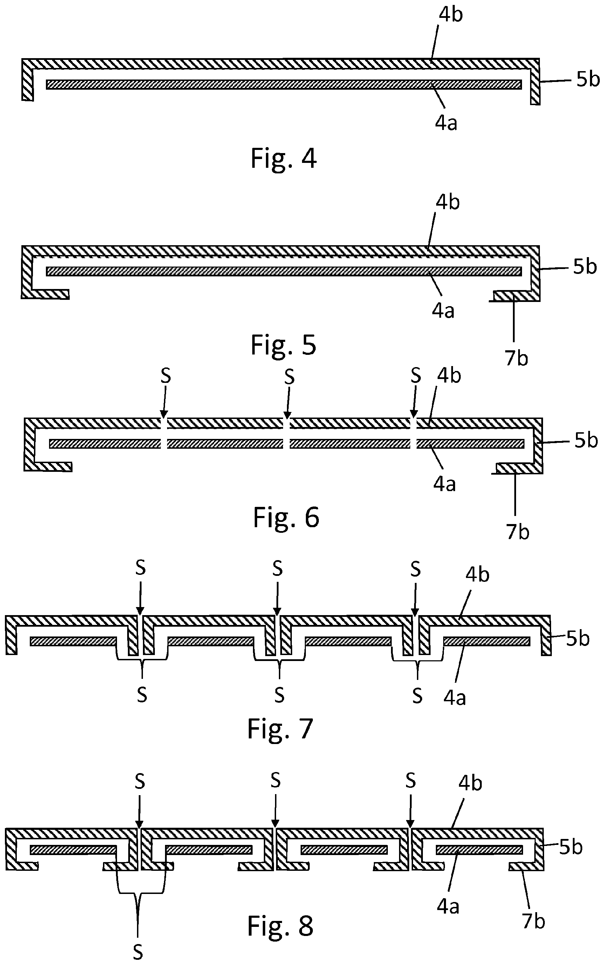

Die anhand Figur 4 erläuterte, dritte Ausführungsform der erfindungsgemäßen Leistungshalbleiteranordnung wird lediglich anhand der Darstellung der Anschlussplatten 4a, 4b beschrieben. Die Anschlussplatten 4a und 4b sind wiederum für die elektrische Kontaktierung mehrerer Halbbrücken 2a, 2b, 2c, 2d vorgesehen und zwar die Anschlussplatte 4a für deren für die Laststromzufuhr vorgesehenen Laststromanschlüsse und die Anschlussplatte 4b für deren für die Laststromabfuhr vorgesehenen Laststromanschlüsse. Bei der vorliegenden Ausführungsform wurde auf die Ausbildung von Schlitzen in den Anschlussplatten 4a, 5b verzichtet. Aber hier ist vorgesehen, dass die für die Laststromabfuhr vorgesehene Anschlussplatte 4b unter Ausbildung von orthogonal zu der zweiten Erstreckungsrichtung verlaufenden Winkelabschnitten 5b entlang beider Längskanten abgekantet ist. Die Winkelabschnitte 5b erstrecken sich dabei über die Anschlussplatte 4a der Laststromzufuhr hinaus, ohne diese zu berühren.

Die in der Figur 5 vorgesehene, vierte Ausführungsform der erfindungsgemäßen Leistungshalbleiteranordnung wird ebenfalls lediglich anhand der Darstellung der Anschlussplatten 4a, 4b beschrieben. Die Anschlussplatten 4a und 4b sind wiederum für die elektrische Kontaktierung mehrerer Halbbrücken 2a, 2b, 2c, 2d vorgesehen und zwar die Anschlussplatte 4a zur Kontaktierung der für die Laststromzufuhr vorgesehenen Laststromanschlüsse und die Anschlussplatte 4b zur Kontaktierung der für die Laststromabfuhr vorgesehenen Laststromanschlüsse. Bei der vierten Ausführungsform wurde auf die Ausbildung von Schlitzen in den Anschlussplatten 4a, 5b verzichtet. Aber hier ist vorgesehen, dass die für die Laststromabfuhr vorgesehene Anschlussplatte 4b unter Ausbildung von orthogonal zu der zweiten Erstreckungsrichtung verlaufenden Winkelabschnitten 5b entlang beider Längskanten abgekantet ist. Die Winkelabschnitte umgreifen hierbei mit ihren Abschnitten 7b die darunter angeordnete, für die Laststromzufuhr vorgesehene Anschlussplatte 4a, ohne diese zu berühren.

Die in der Figur 6 gezeigte, fünfte Ausführungsform der erfindungsgemäßen Leistungshalbleiteranordnung wird ebenfalls lediglich anhand der Darstellung der Anschlussplatten 4a, 4b beschrieben. Die Anschlussplatten 4a und 4b sind wiederum für die elektrische Kontaktierung mehrerer Halbbrücken 2a, 2b, 2c, 2d vorgesehen und zwar die Anschlussplatte 4a zur Kontaktierung der für die Laststromzufuhr vorgesehenen Laststromanschlüsse und die Anschlussplatte 4b zur Kontaktierung der für die Laststromabfuhr vorgesehenen Laststromanschlüsse. Hier ist wie bei der zuvor beschriebenen, vierten Ausführungsform vorgesehen, dass die für die Laststromabfuhr vorgesehene Anschlussplatte 4b unter Ausbildung von orthogonal zu der zweiten Erstreckungsrichtung verlaufenden Winkelabschnitten 5b entlang beider Längskanten abgekantet ist. Die Winkelabschnitte umgreifen hierbei mit ihren Abschnitten 7b die darunter angeordnete, für die Laststromzufuhr vorgesehene Anschlussplatte 4a, ohne diese zu berühren. Neben dieser Maßnahme sind zusätzlich die aus der ersten Ausführungsform bekannten Schlitze S in beiden Anschlussplatten 4a, 4b vorgesehen, die sich parallel zu den Längskanten von einer Einspeisungskante bis zu einem verbleibenden Verbindungssteg erstrecken. Die Schlitze S in beiden Anschlussplatten 4a und 4b sind deckungsgleich ausgebildet und zur Deckung gebracht angeordnet.

Die mit Figur 7 verdeutlichte, sechste Ausführungsform der erfindungsgemäßen Leistungshalbleiteranordnung wird ebenfalls lediglich anhand der Darstellung der Anschlussplatten 4a, 4b beschrieben. Die Anschlussplatten 4a und 4b sind wiederum für die elektrische Kontaktierung mehrerer Halbbrücken 2a, 2b, 2c, 2d vorgesehen und zwar die Anschlussplatte 4a zur Kontaktierung der für die Laststromzufuhr vorgesehenen Laststromanschlüsse und die Anschlussplatte 4b zur Kontaktierung der für die Laststromabfuhr vorgesehenen Laststromanschlüsse. Die Anschlussplatten 4a und 4b weisen wiederum Schlitze S bzw. S' zur bereichsweisen Segmentierung der Anschlussplatten 4a und 4b auf. Die Schlitze S' der für die Laststromzufuhr vorgesehene Anschlussplatte 4a weisen eine größere Breite, d.h. lichten Abstand zwischen den Schlitzkanten, auf als die der Schlitze S, die in der für die Laststromabfuhr vorgesehenen Anschlussplatte 4b eingebracht sind. Hier ist wiederum vorgesehen, dass die für die Laststromabfuhr vorgesehene Anschlussplatte 4b unter Ausbildung von orthogonal zu der zweiten Erstreckungsrichtung verlaufenden Winkelabschnitten 5b entlang beider Längskanten abgekantet ist. Diese sich durch Abkantung ergebenden Winkelabschnitte sind ferner an den die Schlitze definierenden, Schlitzkanten und damit beidseitig vorgesehen. Die Winkelabschnitte 5b durchgreifen hierbei die Schlitze S' der darunter angeordneten Anschlussplatte 4a.

Die in der Figur 8 gezeigte, siebte Ausführungsform der erfindungsgemäßen Leistungshalbleiteranordnung wird ebenfalls lediglich anhand der Darstellung der Anschlussplatten 4a, 4b beschrieben. Die Anschlussplatten 4a und 4b sind wiederum für die elektrische Kontaktierung mehrerer Halbbrücken 2a, 2b, 2c, 2d vorgesehen und zwar die Anschlussplatte 4a zur Kontaktierung der für die Laststromzufuhr vorgesehenen Laststromanschlüsse und die Anschlussplatte 4b zur Kontaktierung der für die Laststromabfuhr vorgesehenen Laststromanschlüsse. Die Anschlussplatten 4a und 4b weisen wiederum Schlitze S bzw. S' zur bereichsweisen Segmentierung der Anschlussplatten 4a und 4b auf. Die Schlitze S' der für die Laststromzufuhr vorgesehene Anschlussplatte 4a weisen eine größere Spaltbreite auf als die der Schlitze S, die in der für die Laststromabfuhr vorgesehenen Anschlussplatte 4b eingebracht sind. Hier ist wiederum vorgesehen, dass die für die Laststromabfuhr vorgesehene Anschlussplatte 4b unter Ausbildung von orthogonal zu der zweiten Erstreckungsrichtung verlaufenden Winkelabschnitten 5b entlang beider Längskanten abgekantet ist. Diese sich durch Abkantung ergebenden Winkelabschnitte sind ferner an den die Schlitze definierenden, Schlitzkanten und damit beidseitig vorgesehen. Die Winkelabschnitte 5b durchgreifen hierbei nicht nur die Schlitze S' der darunter angeordneten Anschlussplatte 4a, sondern umgreifen mit den Abschnitten 7 die darunter angeordnete, für die Laststromzufuhr vorgesehene Anschlussplatte 4a, ohne diese zu berühren.

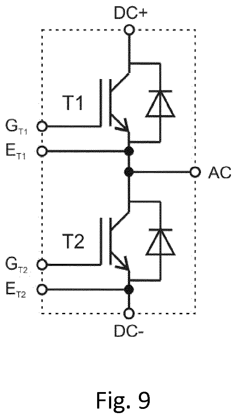

Figur 9 zeigt ein elektronisches Schaltbild für eine Halbbrücke. Diese weist zwei Lastromanschlüsse DC+ und DC- einerseits für die Laststromabfuhr andererseits für die Laststromzufuhr sowie einen Phasenanschluss AC auf. Die gezeigte Halbbrücke weist, zwei jeweils ein IGBT und antiparallel verschaltete Dioden aufweisenden Gleichstromsteller auf. Die IGBTs T1 und T2 werden komplementär über die Gateanschlüsse G_{T1} und G_{T2} angesteuert: Wenn T1 leitet, muss T2 sperren und umgekehrt, so dass aus den anliegenden Lastströmen BC+ und DCin Abhängigkeit des Schaltzustandes ein Wechselstrom am Phasenanschluss AC ausgegeben wird.

All diese den zuvor beschriebenen Ausführungsformen zu entnehmenden Maßnahmen einzeln oder im Zusammenwirken sorgen für eine Beseitigung oder zumindest für eine Verringerung einer Induktivitätsasymmetrie die sich insbesondere bei hochfrequenten Schaltungsvorgängen ergeben im Vergleich zu solchen Ausführungsformen, bei denen die Lastanschlüsse einer Laststromrichtung jeweils über gewöhnliche, über einen Luftspalt beabstandete Anschlussplatten kontaktiert sind. Es wird nochmal ausdrücklich darauf hingewiesen, dass die in den Figuren gezeigte Abkantung der oberen für die Laststromabfuhr vorgesehenen Anschlussplatte 4b alternativ an der unteren für die Laststromzufuhr vorgesehenen Anschlussplatte 4a vorgesehen sein kann.

## Patentansprüche

1. Leistungshalbleiteranordnung (1) mit einer Mehrzahl von parallel zu verschaltenden, in einer Reihe angeordneten, gleichartigen Leistungshalbleiter-Schaltelemente (2a, 2b, 2c, 2d), wobei jedes Leistungshalbleiter-Schaltelement (2a, 2b, 2c, 2d) einen Laststromanschluss (3a) für eine Laststromzufuhr und einen Laststromanschluss (3b) für eine Laststromabfuhr aufweist, und die Laststromanschlüsse derselben Laststromrichtung aus Laststromzufuhr und Laststromabfuhr jeweils, bevorzugt alle Laststromanschlüsse (3a, 3b), auf einer gemeinsamen gedachten Linie (L) angeordnet sind, wobei die Leistungshalbleiteranordnung (1) ferner jeweils eine Anschlussplatte (4a; 4b) pro Laststromrichtung zur jeweils gemeinsamen elektrischen Kontaktierung und Befestigung aller Laststromanschlüsse (3a, 3b) derselben Laststromrichtung aus Laststromzufuhr und Laststromabfuhr aufweist, wobei die Anschlussplatten (4a, 4b) elektrisch isoliert zueinander, zueinander beabstandet, in einer Stapelrichtung (R) gestapelt angeordnet sind, und jede Anschlussplatte (4a, 4b) sich jeweils von einer Einspeisungskante (EK) über die zugehörigen Laststromanschlüsse (4a, 4b) hinweg und diese zum Zwecke der Kontaktierung berührend bis zu einer der Einspeisungskante gegenüberliegenden Endkante (FK) entlang einer ersten Erstreckungsrichtung erstreckt und sich entlang einer zweiten, zur ersten Erstreckungsrichtung orthogonalen und zur gedachten Linie (L) parallelen Erstreckungsrichtung zwischen zwei Längskanten (LK) erstreckt, **dadurch gekennzeichnet, dass** wenigstens eine der Anschlussplatten (4a; 4b) mehrfach mittels zwischen den benachbarten Lastromanschlüssen (3a, 3b) derselben Lastromrichtung verlaufenden Schlitzen (S) geschlitzt ist, so dass die Anschlussplatte (4a, 4b) jeweils durch die Schlitze (S) definierte, jeweils einem Laststromanschluss (3a, 3b) zugeordnete Sektionen (SC1, SC2, SC3, SC4) ausbildet, und benachbarte Sektionen (SC1, SC2, SC3, SC4) lediglich auf der Einspeisungsseite, bevorzugt lediglich an der Einspeisungskante (EK) elektrisch leitend verbunden sind; und/oder **dadurch gekennzeichnet, dass** wenigstens eine der Anschlussplatten (4a, 4b) entlang der Längskanten (LK) in Richtung der anderen Anschlussplatte unter der Ausbildung eines Winkelabschnitts (5b) abgekantet ist.

2. Leistungshalbleiteranordnung (1) gemäß dem vorhergehenden Anspruch, wobei die Schlitze (S) sich ausgehend von der Endkante (FK) in Richtung der Einspeisungskante (EK) bis zu einem von der Anschlussplatte (4a, 4b) ausgebildeten Verbindungssteg (10) zur elektrischen leitenden Verbindung der Sektionen erstreckt.

3. Leistungshalbleiteranordnung (1) gemäß einem der vorhergehenden Ansprüche, wobei die Schlitze (S) sich jeweils parallel zueinander und jeweils entlang der geometrischen Mittelinie zwischen unmittelbar benachbarten Laststromanschlüssen (3a, 3b) entgegengesetzter Laststromrichtungen erstrecken.

4. Leistungshalbleiteranordnung (1) gemäß einem der vorhergehenden Ansprüche, wobei die Laststromanschlüsse (3a, 3b) jeweils näher benachbart zur zugehörigen Endkante (FK) als zur Einspeisungskante (EK) angeordnet sind.

5. Leistungshalbleiteranordnung (1) gemäß einem der vorhergehenden Ansprüche, wobei die Anschlussplatten (4a, 4b) mit parallel verlaufenden, bevorzugt in Stapelrichtung (R) zur Deckung gebracht und deckungsgleich verlaufenden Schlitzen (S) versehen sind.

6. Leistungshalbleiteranordnung (1) gemäß einem der vorhergehenden Ansprüche, wobei die Sektionen (SC1, SC2, SC3, SC4) der jeweils zugehörigen Anschlussplatte (4a, 4b) deckungsgleich ausgebildet sind.

7. Leistungshalbleiteranordnung (1) gemäß einem der vorhergehenden Ansprüche, wobei die Schlitze (S) entlang ihres Verlaufs einen maximalen, bevorzugt einen über ihren Verlauf gleichbleibenden, lichten Abstand von weniger als 5 mm, wie 2,5 mm, bevorzugt weniger als 1 mm aufweisen.

8. Leistungshalbleiteranordnung (1) gemäß einem der vorhergehenden Ansprüche, wobei die Schlitze (S) eine Länge von mehr als 2,5 cm bis 10,0 cm, bevorzugt mehr als 3,5 cm bis 8,0 cm aufweisen.

9. Leistungshalbleiteranordnung (1) gemäß einem der vorhergehenden Ansprüche, wobei der Verbindungssteg (10) eine Breite von weniger als 1,5 cm, bevorzugt weniger als 1,0 cm aufweist.

10. Leistungshalbleiteranordnung (1) gemäß einem der vorhergehenden Ansprüche, wobei die Schlitze (S) zugehörige Schlitzkanten definieren und wenigstens eine der Anschlussplanten entlang der Schlitzkanten in Richtung der anderen Anschlussplatte unter Ausbildung von Winkelabschnitten abgekantet ist.

11. Leistungshalbleiteranordnung (1) gemäß einem der vorhergehenden Ansprüche, wobei die Anschlussplatten (4a, 4b) jeweils aus gelasertem oder gestanztem Metallblech, wie Kupferblech, hergestellt sind.

12. Leistungshalbleiteranordnung (1) gemäß einem der vorhergehenden Ansprüche, wobei wenigstens eine der Anschlussplatten (4a, 4b) mehrere Durchbrüche (6a, 6b) aufweist, die jeweils für die Durchführung und/oder den Zugriff zu einem der Laststromanschlüsse (3a, 3b) vorgesehen sind und wobei der Durchbruch (6a, 6b) jeweils eine geschlossen umlaufende, bevorzugt kreisrunde, Durchbruchkante definiert.

13. Leistungshalbleiteranordnung (1) gemäß einem der vorhergehenden Ansprüche, wobei die Leistungshalbleiter-Schaltelemente (2a, 2b, 2c, 2d) jeweils ein Modulgehäuse aufweisen.

14. Leistungshalbleiteranordnung (1) gemäß dem vorhergehenden Anspruch, wobei die Modulgehäuse der Leistungshalbleiteranordnung (1) identisch ausgebildet sind.

15. Leistungshalbleiteranordnung (1) gemäß einem der beiden vorhergehenden Ansprüche, wobei die Anschlussplatten (4a, 4b) die eine alle Modulgehäuse der Leistungshalbleiteranordnung (1) umgebende Kühleinrichtung überbrückend angeordnet sind.

16. Leistungshalbleiteranordnung (1) gemäß einem der vorhergehenden Ansprüche 13 bis 15, wobei die Modulgehäuse lange und kurze Flanken aufweisen, die so angeordnet sind, dass bis auf eine Flanke des äußersten Modulgehäuses jeweils eine lange Flanke eines Modulgehäuses nächstbenachbart, beispielsweise angrenzend, mit einer Flanke eines anderen Modulgehäuses angeordnet ist.

17. Leistungshalbleiteranordnung (1) gemäß dem vorhergehenden Anspruch, wobei die Einspeisungskante (EK) über den kurzen Flanken der Modulgehäuse und der Verbindungssteg (10) jeweils über den gegenüberliegenden kurzen Flanken der Modulgehäuse angeordnet sind.

18. Leistungshalbleiteranordnung (1) gemäß einem der vorhergehenden Ansprüche, wobei die Leistungshalbleiter-Schaltelemente (2a, 2b, 2c, 2d) jeweils als eine Halbbrücke ausgebildet sind.

19. Verwendung der Leistungshalbleiteranordnung (1) gemäß einem der vorhergehenden Ansprüche als Stromrichter, bevorzugt als Wechselrichter, noch bevorzugter als Spannungszwischenkreiswechselrichter.

## Claims

1. A power semiconductor arrangement (1) having a plurality of similar power semiconductor switching elements (2a, 2b, 2c, 2d) to be connected in parallel and arranged in a row, each power semiconductor switching element (2a, 2b, 2c, 2d) having a load current terminal (3a) for a load current supply and a load current terminal (3b) for a load current discharge, and the load current terminals of the same load current direction of load current supply and load current discharge are each, preferably all load current terminals (3a, 3b), arranged on a common imaginary line (L), wherein the power semiconductor arrangement (1) further comprises a respective terminal plate (4a; 4b) per load current direction for the respective common electrical contacting and fastening of all load current terminals (3a, 3b) of the same load current direction of load current supply and load current discharge, wherein the terminal plates (4a, 4b) are arranged electrically insulated from one another, spaced apart from one another, stacked in a stacking direction (R), and each terminal plate (4a, 4b) extends from a feed edge (EK) beyond the associated load current terminals (4a, 4b) and, for the purpose of making contact, in a contact with the latter up to an end edge (FK) opposite the feed edge along a first extending direction, and extends along a second extending direction between two longitudinal edges (LK), which is orthogonal to the first extending direction and parallel to the imaginary line (L),
**characterized in that**
at least one of the terminal plates (4a; 4b) is slotted several times by means of slots (S) extending between the adjacent load current terminals (3a, 3b) of the same load current direction, so that the terminal plate (4a, 4b) is formed by adjacent sections (SC1, SC2, SC3, SC4) associated to one of the load current terminals (3a, 3b) and defined by the slots (S), respectively, and adjacent sections (SC1, SC2, SC3, SC4) are electrically conductively connected only on the feed side, preferably only at the feed edge (EK); and/or
**characterized in that**
at least one of the terminal plates (4a, 4b) is bent along the longitudinal edges (LK) in the direction of the other terminal plate to form an angular section (5b).

2. The power semiconductor device (1) according to the preceding claim, the slots (S) extending from the end edge (FK) in the direction of the feed edge (EK) up to a connecting web (10) formed by the terminal plate (4a, 4b) for the electrical conductive connection of the sections.

3. The power semiconductor device (1) according to one of the preceding claims, the slots (S) each extending parallel to each other and along the geometric center line between immediately adjacent load current terminals (3a, 3b) of opposite load current directions.

4. The power semiconductor device (1) according to one of the preceding claims, each load current terminal (3a, 3b) being arranged closer adjacent to the associated end edge (FK) than to the feed edge (EK).

5. The power semiconductor arrangement (1) according to one of the preceding claims, wherein the terminal plates (4a, 4b) are provided with slots (S) which extend in parallel to each other and are preferably brought into congruence in the stacking direction (R) and run congruent to each other.

6. The power semiconductor arrangement (1) according to one of the preceding claims, the sections (SC1, SC2, SC3, SC4) of the respective associated terminal plate (4a, 4b) are formed in congruence to each other.

7. The power semiconductor arrangement (1) according to one of the preceding claims, wherein the slots (S) along their course have a maximum, preferably a constant, clear distance over their course, of less than 5 mm, such as 2.5 mm, preferably less than 1 mm.

8. The power semiconductor device (1) according to one of the preceding claims, the slots (S) having a length of more than 2.5 cm to 10.0 cm, preferably more than 3.5 cm to 8.0 cm.

9. The power semiconductor device (1) according to one of the preceding claims, wherein the connecting web (10) has a width of less than 1.5 cm, preferably less than 1.0 cm.

10. The power semiconductor device (1) according to one of the preceding claims, wherein the slots (S) define associated slot edges and at least one of the terminal plates is bent along the slot edges towards the other terminal plate to form angular portions.

11. The power semiconductor arrangement (1) according to one of the preceding claims, wherein the terminal plates (4a, 4b) are each made of lasered or punched metal sheet, such as copper sheet.

12. The power semiconductor arrangement (1) according to one of the preceding claims, wherein at least one of the terminal plates (4a, 4b) has a plurality of apertures (6a, 6b) which are each provided for the passage through and/or the access to one of the load current terminals (3a, 3b), and wherein each aperture (6a, 6b) defines a closed circumferential, preferably circular, aperture edge.

13. The power semiconductor arrangement (1) according to one of the preceding claims, wherein the power semiconductor switching elements (2a, 2b, 2c, 2d) each have a module housing.

14. The power semiconductor arrangement (1) according to the preceding claim, wherein the module housings of the power semiconductor arrangement (1) are identically formed.

15. The power semiconductor device (1) according to one of the two preceding claims, wherein the terminal plates (4a, 4b) are arranged to bridge a cooling means surrounding all module housings of the power semiconductor device (1).

16. The power semiconductor device (1) according to one of the preceding claims 13 to 15, the module housings having long and short edges are arranged such that, except for one edge of the outermost module housing, a respective long edge of a module housing is arranged in closest neighborship, for example adjacent, to one edge of another module housing.

17. The power semiconductor device (1) according to the preceding claim, wherein the feed edge (EK) is arranged over the short edges of the module housings and the connecting web (10) is arranged over the opposite short edges of the module housings, respectively.

18. The power semiconductor device (1) according to one of the preceding claims, wherein the power semiconductor switching elements (2a, 2b, 2c, 2d) are each formed as a half-bridge.

19. A use of the power semiconductor device (1) according to one of the preceding claims as a power converter, preferably as an inverter, even more preferably as an intermediate circuit voltage inverter.

## Revendications

1. Système à semi-conducteurs de puissance (1) avec une pluralité d'éléments de commutation à semi-conducteurs de puissance (2a, 2b, 2c, 2d) similaires à interconnecter en parallèle disposés en série, chaque élément de commutation à semi-conducteurs de puissance (2a, 2b, 2c, 2d) présentant un raccordement de courant de charge (3a) pour une admission de courant de charge et un raccordement de courant de charge (3b) pour une évacuation de courant de charge, et les raccordements de courant de charge du même sens de courant de charge à partir de l'admission de courant de charge et de l'évacuation de courant de charge, de préférence tous les raccordements de courant de charge (3a, 3b), étant respectivement disposés sur une ligne imaginaire (L) commune, le dispositif à semi-conducteurs de puissance (1) présentant en outre respectivement une plaque de raccordement (4a ; 4b) par sens de courant de charge pour respectivement une mise en contact électrique commune et une fixation de tous les raccordements de courant de charge (3a, 3b) du même sens de courant de charge à partir de l'alimentation en courant de charge et de l'évacuation de courant de charge, les plaques de raccordement (4a, 4b) étant disposées de manière empilée dans un sens d'empilement (R) en étant isolées électriquement l'une de l'autre, à distance l'une de l'autre, et chaque plaque de raccordement (4a, 4b) s'étendant le long d'un premier sens d'extension respectivement à partir d'un bord d'alimentation (EK) jusqu'à l'un des bords d'extrémité (FK) opposés au bord d'alimentation en passant par-dessus les raccordements de courant de charge (4a, 4b) correspondants et en touchant ceux-ci à des fins de mise en contact et s'étendant le long d'un second sens d'extension orthogonal au premier sens d'extension et parallèle à la ligne imaginaire (L) entre deux bords longitudinaux (LK), **caractérisé en ce que**
au moins l'une des plaques de raccordement (4a ; 4b) est rainurée à plusieurs reprises au moyen de rainures (S) s'étendant entre les raccordements de courant de charge (3a, 3b) adjacents du même sens de courant de charge, de sorte que la plaque de raccordement (4a, 4b) réalise des sections (SC1, SC2, SC3, SC4), définies respectivement par les rainures (S), associées respectivement à un raccordement de courant de charge (3a, 3b), et des sections (SC1, SC2, SC3, SC4) adjacentes sont reliées de manière électriquement conductrice uniquement sur la face d'alimentation, de préférence uniquement au niveau du bord d'alimentation (EK) ;
et/ou **caractérisé en ce que**
au moins l'une des plaques de raccordement (4a, 4b) est biseautée le long des bords longitudinaux (LK) dans la direction de l'autre plaque de raccordement en réalisant un secteur angulaire (5b).

2. Système à semi-conducteurs de puissance (1) selon la revendication précédente, **caractérisé en ce que** les rainures (S) s'étendent en partant du bord d'extrémité (FK) dans la direction du bord d'alimentation (EK) jusqu'à un pont de liaison (10) réalisé par la plaque de raccordement (4a, 4b) pour la liaison électriquement conductrice des sections.

3. Système à semi-conducteurs de puissance (1) selon l'une des revendications précédentes, **caractérisé en ce que** les rainures (S) s'étendent respectivement parallèlement les unes aux autres et respectivement le long de l'axe central géométrique entre des raccordements de courant de charge (3a, 3b) directement adjacents de sens de courant de charge opposés.

4. Système à semi-conducteurs de puissance (1) selon l'une des revendications précédentes, **caractérisé en ce que** les raccordements de courant de charge (3a, 3b) sont disposés respectivement plus près de manière adjacente du bord d'extrémité (FK) correspondant que du bord d'alimentation (EK).

5. Système à semi-conducteurs de puissance (1) selon l'une des revendications précédentes, **caractérisé en ce que** les plaques de raccordement (4a, 4b) sont dotées de rainures (S) parallèles, de préférence mises en chevauchement et de manière à coïncider dans la direction d'empilement (R).

6. Système à semi-conducteurs de puissance (1) selon l'une des revendications précédentes, **caractérisé en ce que** les sections (SC1, SC2, SC3, SC4) de la plaque de raccordement (4a, 4b) respectivement correspondante sont réalisées de manière à coïncider.

7. Système à semi-conducteurs de puissance (1) selon l'une des revendications précédentes, **caractérisé en ce que** les rainures (S) présentent le long de leur étendue un écartement maximal, de préférence constant sur leur étendue, de moins de 5 mm, comme 2,5 mm, de préférence de moins de 1 mm.

8. Système à semi-conducteurs de puissance (1) selon l'une des revendications précédentes, **caractérisé en ce que** les rainures (S) présentent une longueur de plus de 2,5 cm à 10,0 cm, de préférence de plus de 3,5 cm à 8,0 cm.

9. Système à semi-conducteurs de puissance (1) selon l'une des revendications précédentes, **caractérisé en ce que** le pont de liaison (10) présente une largeur de moins de 1,5 cm, de préférence de moins de 1,0 cm.

10. Système à semi-conducteurs de puissance (1) selon l'une des revendications précédentes, **caractérisé en ce que** les rainures (S) définissent des bords de rainure correspondants et au moins l'une des plaques de raccordement est biseautée le long des bords de rainure dans la direction de l'autre plaque de raccordement en réalisant des secteurs angulaires.

11. Système à semi-conducteurs de puissance (1) selon l'une des revendications précédentes, **caractérisé en ce que** les plaques de raccordement (4a, 4b) sont respectivement fabriquées à partir d'une tôle métallique découpée au laser ou estampée, comme une tôle de cuivre.

12. Système à semi-conducteurs de puissance (1) selon l'une des revendications précédentes, **caractérisé en ce qu'**au moins l'une des plaques de raccordement (4a, 4b) présente plusieurs ouvertures (6a, 6b) qui sont prévues respectivement pour le passage de l'un des raccordements de courant de charge (3a, 3b) et/ou l'accès à l'un de ceux-ci et **en ce que** l'ouverture (6a, 6b) définit respectivement un bord d'ouverture fermé périphérique, de préférence rond.

13. Système à semi-conducteurs de puissance (1) selon l'une des revendications précédentes, **caractérisé en ce que** les éléments de commutation à semi-conducteurs de puissance (2a, 2b, 2c, 2d) présentent respectivement un boîtier de module.

14. Système à semi-conducteurs de puissance (1) selon la revendication précédente, **caractérisé en ce que** les boîtiers de module du système à semi-conducteurs de puissance (1) sont réalisés de manière identique.

15. Système à semi-conducteurs de puissance (1) selon l'une des deux revendications précédentes, **caractérisé en ce que** les plaques de raccordement (4a, 4b) sont disposées de manière à enjamber un dispositif de refroidissement entourant tous les boîtiers de module du système à semi-conducteurs de puissance (1).

16. Système à semi-conducteurs de puissance (1) selon l'une des revendications précédentes 13 à 15, **caractérisé en ce que** les boîtiers de module présentent des flancs longs et courts qui sont disposés de sorte que, jusqu'à un flanc du boîtier de module le plus extérieur, un flanc long d'un boîtier de module soit disposé respectivement au voisinage, par exemple de manière adjacente, d'un flanc d'un autre boîtier de module.

17. Système à semi-conducteurs de puissance (1) selon la revendication précédente, **caractérisé en ce que** le bord d'alimentation (EK) est disposé par-dessus les flancs courts des boîtiers de module et le pont de liaison (10), respectivement par-dessus les flancs courts opposés des boîtiers de module.

18. Système à semi-conducteurs de puissance (1) selon l'une des revendications précédentes, **caractérisé en ce que** les éléments de commutation à semi-conducteurs de puissance (2a, 2b, 2c, 2d) sont réalisés respectivement en tant que demi-pont.

19. Système à semi-conducteurs de puissance (1) selon l'une des revendications précédentes en tant que convertisseur de courant, de préférence en tant que convertisseur de courant continu-alternatif, de manière davantage préférée en tant que convertisseur de circuit intermédiaire de tension.
